# EUROPÄISCHE PATENTANMELDUNG

(11) **EP 2 148 395 A2**
(43) Veröffentlichungstag der Anmeldung: **27.01.2010**
(21) Anmeldenummer: 09006656.4
(22) Anmeldetag: 18.05.2009
(51) Int. Cl.: H01R 13/24

(54) **Lötkontaktvorrichtung**

(30) Priorität: 26.07.2008 DE 102008035056
(71) Anmelder: Amphenol-Tuchel Electronics GmbH, 74080 Heilbronn (DE)
(72) Erfinder: Kuntz, Julio, 74861 Neudenau (DE); Niedenzu, Volker, 74172 Neckarsulm (DE)

(57) **Zusammenfassung**

Die Erfindung betrifft eine Lötkontaktvorrichtung zur elektrischen Verbindung mit einer Leiterplatte umfassend mindestens zwei zueinander beabstandete Kontaktelemente, sowie eine im wesentlichen formstabile Folie, welche mit den Kontaktelementen mechanisch an deren Oberfläche verbunden ist, wobei die Folie als schmelzbare Folie ausgebildet ist, welche sich bei Erhitzen auf eine typische Löttemperatur verflüssigt und dabei die Verbindung zwischen den Kontaktelementen getrennt wird.

## Beschreibung

Die Erfindung bezieht sich allgemein auf eine Lötkontaktvorrichtung, sowie ein Verfahren zur deren Herstellung.

Die Erfindung bezweckt eine flache Bauweise von Kontaktanordnungen, insbesondere zur Kontaktierung von Chipkarten.

Im Stand der Technik sind eine Reihe von SIM-Kartenkontaktiervorrichtungen oder allgemein Kartenkontaktiervorrichtungen bekannt, welche aus einem Gehäuse, einem Kontaktträger und im Kontaktträger befindliche federnde Kontakte bestehen. Im Hinblick auf die zunehmende Miniaturisierung in der Elektronikindustrie und deren Anwendungen insbesondere im Bereich von Mobilfunkanwendungen, werden immer kleinere und immer dünnere Kontaktiervorrichtungen benötigt. Dabei treten insbesondere bei der Herstellung fertigungsbedingte Schwierigkeiten auf. Ein dem Fachmann geläuflges Problem ist, das der Koplanarität, welches ein hergeht mit abnehmender Höhe und Kombination von Kontakten mit Kontaktkörpern unterschiedlicher Fertigungstoleranz. Im Zweifel kann es passieren, dass die Kontaktfüße mit ihren Lötanschlüssen, welche aus einem Kontaktträger herausragen, zur Lötung auf einer Leiterplatte nicht in einer Ebene liegen und möglicherweise einzelne Verbindungen nicht verlötet werden. Im Zweifel kommt es dann zur Störung oder zum Ausfall der gesamten Baugruppe.

Im Stand der Technik befasst sich die DE 10 2006 005 275 A1 mit der Herstellung einer superflachen Simblock-Einrichtung, die universell, vorzugsweise in einem Telefon, insbesondere in einem Handy, eingesetzt werden kann, wo wegen der Handlichkeit des Handys eine größtmögliche Platzeinsparung erreicht werden muss. Der superflache Simblock soll vorzugsweise derart ausgelegt sein, dass eine SIM-Karte nicht nur sicher in eine Richtung in dem Bereich der Kontaktierungsseite, das heißt, dort wo sich die Kontaktkuppen der Kontaktelemente befinden, eingeführt werden kann, sondern vorzugsweise aus einem verhältnismäßig großem Bereich von Einführ,- Insbesondere Einschlebrichtungen. Vorzugsweise soll es möglich sein, dass die SIM-Karte ohne weiteres aus einem Bereich von insbesondere 90° und mehr eingeschoben werden kann.

Dies wird erzlelt durch eine spezielle Anordnung und Form der Kontaktelemente, die nicht desto trotz eine gewisse Höhe eines Kontaktträgers benötigen. Ferner besteht die Schwierigkeit darin, dass beim Verpressen der Kontaktelemente in den Kontaktkörper die spezielle Geometrie der Kontakte auch im Bereich ihrer Kontaktkuppen verformt wird, was neben den zuvor genannten Nachteilen bei der Verbindung mit einer Leiterplatte auch zu Problemen bei der Kontaktierung mit einer zu lesenden Karte mit sich bringt.

Es gibt bereits zahlreiche Kontaktiereinrichtungen für Karten oder SIM-Karten, die häufig auch in Form eines Kartenblocks ausgebildet sind, das heißt, einem Kontaktträger aus Kunststoff, in dem Kontaktelemente befestigt sind, die mit den Kontaktzonen einer SIM-Karte zusammen arbeiten. Ein Simblock hat üblicherweise keinen Deckel und das Andrücken der SIM-Karte erfolgt daher durch ein im Gerät vorgesehene Abstützfläche. Diese Situation führt weiterhin zu einer Problematik, dass trotz der fertigungsbedingten Toleranzen auch die Einbaulage eines solchen Simblocks in Bezug auf eine entsprechende Anlage oder Abstützfläche für die Karte sehr exakt ausgebildet sein muss, also eine Funktion ist, in Abhängigkeit von der Lage der Leiterplatte, auf welche eine solche Kontaktvorrichtung aufgelötet wird.

Aufgabe der vorliegenden Erfindung besteht darin, eine Alternative zu den bisherigen Kontaktvorrichtungen zu finden, insbesondere eine solche Kontaktvorrichtung zu schaffen, bei der der Kontaktkörper entfällt und daher die Höhe einer solchen Kontaktvorrichtung einzig durch die Höhe der Kontaktelemente bestimmt wird.

Weitere Aufgabe der vorliegenden Erfindung ist es, eine solche Kontaktvorrichtung bereit zu stellen, die auch die Probleme der Koplanarität umgeht.

Die Erfindung sieht daher eine Lötkontaktvorrichtung vor, welche komplett auf einen Kontaktträger verzichtet und statt des Kontaktträgers, welcher üblicherweise aus Kunststoff oder isolierendem Material besteht, durch eine leitfähige Lötpaste ersetzt. Diese Lötpaste dient zur Verbindung der einzelnen Kontakte untereinander sozusagen als Montagehilfe und wird während des Lötprozesses, beispielsweise in einem Reflowlötverfahren geschmolzen, wobei gleichzeitig das Lötmaterial die Kontakte auf die Platine lötet.

Die Vortelle der Erfindung gegenüber dem Stand der Technik liegen Insbesondere daher in dem verringerten Bauraum, bei gleichzeitiger Einhaltung der Koplanarität und Verringerung der Montagekosten. Insbesondere wird auch ein Kunststoffkörper und damit Material eingespart.

Erfindungsgemäß werden mehrere paarweise beabstandete Kontakte so mit einer flächigen Lötfolie verbunden, dass diese in gewünschter Form, Größe und Abstand zueinander auf den entsprechenden Lötpads einer Leiterplatte positionierbar sind.

Die erfindungsgemäße Lötkontaktvorrichtung wird zum Verbinden mit einer Leiterplatte auf diese mittels einer Montagehilfsvorrichtung aufgesetzt und erhitzt. Während des Aufwärmens im Bereich der Kontaktierung oder durch eine Erhöhung der Umgebungstemperatur, die beispielsweise in einem Reflowlötprozess geschehen kann, schmilzt die Verbindungsfolie und positioniert die Kontakte direkt auf den Lötpads der Leiterplatte.

Die erfindungsgemäße Lötkontaktvorrichtung kann eine Vielzahl von unterschiedlich beabstandeten Kontakten umfassen, welche nach dem gleichen Prinzip in einem Erwärmungsprozess bis an eine Lötgrenztemperatur aufgeschmolzen und dabei auf die Platine aufgelötet werden.

Weitere Vorteile, Ziele und Einzelheiten der Erfindung ergeben sich aus Ansprüchen, wobei im folgenden die Erfindung anhand eines Ausführungsbeispiels beschrieben wird, welches sich auf eine drelpollge Lötkontaktvorrichtung bezieht. Weiterhin wird ein Verfahren beansprucht, zur Herstellung einer solchen Lötkontaktvorrichtung.
In der Zeichnung zeigt:
Fig. 1 eine Seitenansicht der erfindungsgemäßen Lötkontaktvorrichtung;
Fig. 2 eine Draufsicht auf die Lötkontaktvorrichtung gemäß Fig. 1,

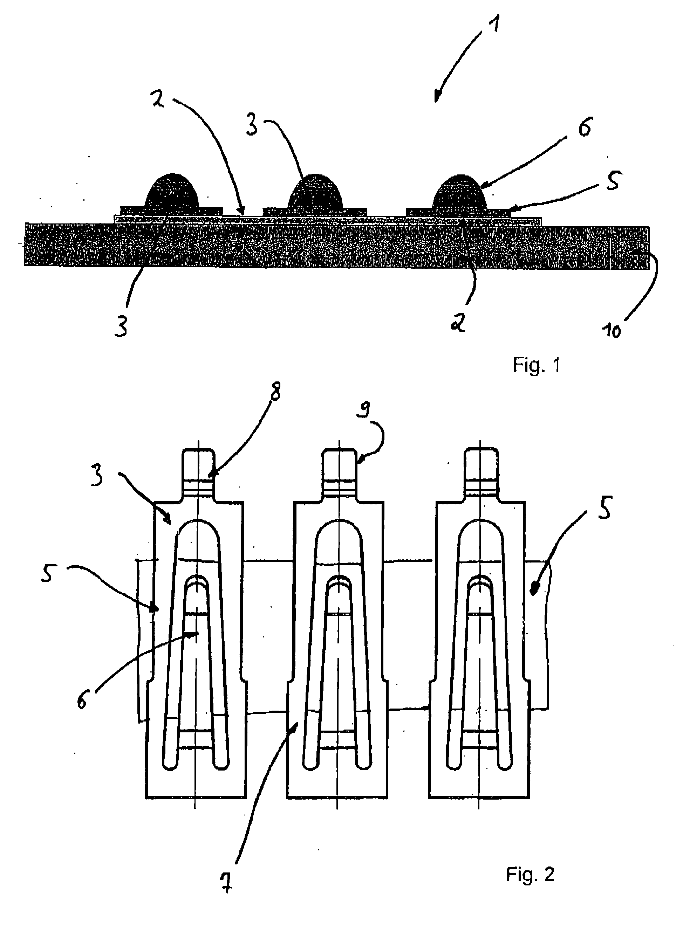

In den Fig. 1 bis Fig. 2 ist eine Lötkontaktvorrichtung 1 montiert auf eine Leiterplatte 10 gezeigt. In dem in Fig. 1 gezeigten Zustand ist die Folie 2, welche zwischen den Kontakten 3 und der Leiterplatte 10 befindlich angeordnet ist, noch in einem nicht aufgeschmolzenen Zustand.

Nicht dargestellt ist die Situation nach dem Lötprozess, wo die Kontaktelemente 3 um eine definierte Distanz in Abhängigkeit von der Beschaffenheit der Folie 2 in Richtung der Oberfläche der Leiterplatte 10 gelangen und damit in eine definierte Abstandsposition, wobei gleichzeitig die Anschlussebenen der Kontaktelemente 3 mit der Leiterplatte 10 verlötet werden.

In der in Fig. 1 dargestellten Ausgangssituation bietet die Leiterplatte 10 eine Anzahl von nicht dargestellten Lötpads 11. Auf die Leiterplatte 10 wird die Lötkontaktiervorrichtung 1 aufgesetzt. Die erfindungsgemäße Lötkontaktiervorrichtung 1 umfasst drei paarweise zueinander beabstandete Kontaktelemente 3, welche mechanisch verbunden sind mit einer Folie 2, wobei im vorliegenden Beispiel die Folie 2 als Lötmaterialfolie 2 ausgestattet ist. Die Folie 2 kann aus einem beliebigen schmelzenden Material ausgebildet sein, welches gefüllt ist mit Lötmaterial. Wesentlich dabei ist, dass die Folie 2 formstabil bleibt und so ausgebildet ist, dass nach Befestigung der Kontaktelemente 3 mit der Folie 2 eine formstabile im wesentlichen ebene Kontaktiervorrichtung gebildet wird. Die Folie 2 kann In ihrer Dicke und Beschaffenheit so gewählt werden, dass sie nach dem Aufschmelzen durch Erwärmung den gewünschten Anteil an Lot und damit den gewünschten Abstand zur Leiterplatte 10 definiert.

Im vorliegenden Fall ist die Folie 2 ausgebildet aus einer gewalzten Lötfolie, welche im Reflowlötprozess aufschmilzt und die Verbindung der Kontaktelemente 3 mit dem Lötpads 11 der Leiterplatte 10 bildet.

In der Fig. 2 genauer dargestellt, sind die Kontaktelemente 3 mit ihrem Verbindungsabschnitt 5 auf der Folie 2.

Nicht dargestellt ist hier die Leiterplatte 10.

Die Kontaktelemente 3 umfassen einen Kontaktelementrahmen 7, welcher an einem Ende die Kontaktfeder 6 umfasst, die wiederum federnd aus dem Kontaktelementrahmen 7 herausragt. An einem Ende des Kontaktelementrahmens 7 befinden sich je einen Kontaktlippe 8, welche so nach unten in Richtung zur Leiterplatte 10 gebogen ist, mit einem im wesentlichen flachen Unterteil 9, dass dies dem Abstand zur Leiterplatte definiert und damit die Foliendicke bestimmt.

### Bezugszelchenliste

### Lötkontaktvorrichtung

- 1: Lötkontaktvorrichtung
- 2: Folie
- 3: Kontaktelemente
- 4: Lötflächen
- 5: Verbindungsabschnitt
- 6: Kontaktfedern
- 7: Kontaktelementrahmen
- 8: Kontaktlippen
- 9: Kontaktlippenunterseite
- 10: Leiterplatte
- 11: Lötpads

## Patentansprüche

1. Lötkontaktvorrichtung (1) zur elektrischen Verbindung mit einer Leiterplatte (10), umfassend mindestens zwei zueinander beabstandete Kontaktelemente (3), sowie eine im wesentlichen formstabile Folie (2), welche mit dem Kontaktelementen (3) mechanisch an deren Oberfläche verbunden ist, **dadurch gekennzeichnet, dass** die Folie (2) als schmelzbare Folie ausgebildet ist, welche sich bei Erhitzen bei eine typischen Löttemperatur verflüssigt und dabei die von der Folle gebildete Verbindung zwischen den Kontaktelementen getrennt wird.

2. Lötkontaktvorrichtung (1) gemäß Anspruch 1, **dadurch gekennzeichnet, dass** die Folie (2) zumindest teilweise aus Lotmaterial besteht.

3. Lötkontaktvorrichtung (1) gemäß Anspruch 1 oder 2, **dadurch gekennzeichnet, dass** die Folie (2) eine Lötfolie darstellt, die nahezu vollständig aus Lotmaterial hergestellt ist, vorzugsweise über 95 % Gewichtsanteil Lötmaterial umfasst.

4. Lötkontaktvorrichtung (1) gemäß Anspruch 2 oder 3, **dadurch gekennzeichnet, dass** das Lotmaterial der Lötfolie vollständig und automatisch im Lötprozess als Verbindungslot an den Kontaktstellen zur Verbindung mit der Leiterplatte dient.

5. Lötkontaktelement (3) gemäß Anspruch 1 bis 4, **dadurch gekennzeichnet, dass** die Kontaktelemente (3) einen Kontaktelementrahmen (7) umfassen mit einem Verbindungsabschnitt (5), welcher mit der Oberfläche der Folle (2) verbunden Ist.

6. Lötkontaktvorrichtung (1) gemäß einem der vorhergehenden Ansprüche, **dadurch gekennzeichnet, dass** die Kontaktelemente (3) über eine Kontaktlippe (8) verfügen, welche mit ihrer Kontaktlippenunterseite (9) eine Ebene mit der Folie (2) aufspannen und bilden.

7. Verfahren zur Herstellung einer Lötkontaktvorrichtung (1) gemäß einem der Ansprüche 1 bis 6, umfassend die folgenden Schritte:
a) Bereitstellen einer im wesentlichen formstabilen schmelzbaren Folie (2), welche zumindest teilweise aus Lotmaterial ausgebildet ist;
b) Bereitstellen von mindestens zwei paarweise beabstandeten Kontaktelementen (3) mit Verbindungsabschnitten (5) an den Kontaktelementen (3);
c) Verbinden der Kontaktelemente (3) mit ihren Verbindungsabschnitten (5) mit der Oberfläche der Folie (2).
